Europäisches Patentamt

European Patent Office

Office européen des brevets

(19)

(11) EP 0 710 421 B1

(12) **FASCICULE DE BREVET EUROPEEN**

(45) Date de publication et mention
de la délivrance du brevet:
**17.02.1999 Bulletin 1999/07**

(21) Numéro de dépôt: **94922937.1**

(22) Date de dépôt: **19.07.1994**

(51) Int Cl.⁶: **H04N 7/24**

(86) Numéro de dépôt international:
**PCT/FR94/00900**

(87) Numéro de publication internationale:
**WO 95/03673 (02.02.1995 Gazette 1995/06)**

(54) **PROCEDE ET DISPOSITIF D'ESTIMATION D'UN BUDGET DE BITS POUR ENCODEURS A LONGUEUR DE MOT VARIABLE**

VERFAHREN UND VORRICHTUNG ZUR BITMENGENSCHÄTZUNG FÜR EINEN KODIERER MIT VARIABLER KODEWORTLÄNGE

BIT BUDGET ESTIMATION METHOD AND DEVICE FOR VARIABLE WORD LENGTH ENCODERS

(84) Etats contractants désignés:
**DE ES FR GB IT NL SE**

(30) Priorité: **20.07.1993 FR 9308892**

(43) Date de publication de la demande:
**08.05.1996 Bulletin 1996/19**

(73) Titulaire: **THOMSON multimedia**
**92648 Boulogne Cédex (FR)**

(72) Inventeur: **YASSA, Fathy**
**F-92402 Courbevoie Cédex (FR)**

(74) Mandataire: **Ruellan-Lemonnier, Brigitte et al**
**THOMSON multimedia,**
**46 quai A. Le Gallo**
**92648 Boulogne Cédex (FR)**

(56) Documents cités:
**EP-A- 0 419 141**          **EP-A- 0 480 353**
**US-A- 4 984 076**          **US-A- 5 170 264**

- **A. NETRAVALI AND B. HASKELL 'Digital pictures : representation and compression' 1988 , PLENUM PRESS , NEW-YORK Chapitre 3 : voir page 148, ligne 12 - page 155, ligne 3**

## Description

La présente invention se rapporte à un procédé d'estimation d'un budget de bits pour encodeurs à longueur de mot variable, ainsi qu'à un dispositif de compression d'images mettant en oeuvre ce procédé.

Dans le domaine de la compression d'images, notamment dans le domaine de la télévision à haute définition, les images à compresser sont soumises à différents traitements (estimations du mouvement, transformation dans le domaine des fréquences, par exemple par DCT ("Discrete Cosine Transform" en terminologie anglaise), avant que les données ainsi obtenues soient codées pour la transmission. Pour éliminer les données redondantes tout en conservant l'intégrité des informations, on peut faire appel aux procédés de codage à longueur de mot variable ("Variable lenght coding" ou VLC en terminologie anglo-saxonne). Ces procédés, dont celui mentionné dans le document "Plenum Press : Digital Pictures : representation and compression, de A. Netravali et al., 1988, pages 148 à 155", qui décrit le codage Huffman, tiennent compte de la probabilité d'apparition des données parmi l'ensemble des mots possibles pour ces données. Seront alors codés par des mots binaires courts les mots apparaissant souvent et par des mots binaires plus longs les mots apparaissant moins souvent. Ceci aura pour conséquence une diminution de la longueur de mot moyenne, c'est-à-dire une diminution du nombre de bits à transmettre. Le document EP-A-0 419 141 décrit un procédé de codage à longueur variable, et concerne un procédé de réduction du taux de bits lors d'une transmission, où les blocs de données sont codés par un codage Huffman, la longueur des blocs codés étant fixe.

Un exemple d'un dispositif utilisant un tel codage à longueur variable est décrit ci-dessous.

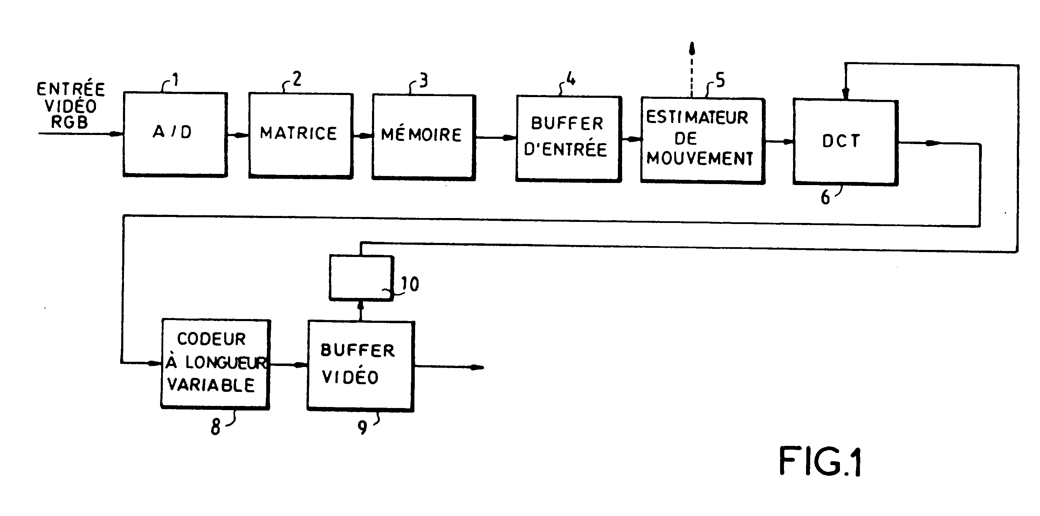

Selon un exemple simplifié de circuit de compression représenté à la figure 1, un signal vidéo RGB est numérisé par un convertisseur analogique/numérique 1, alimentant une matrice de conversion RGB/YUV 2, dont la sortie est connectée à une mémoire image 3. Un buffer d'entrée 4 fait l'interface entre la mémoire image 3 et le ou les estimateur(s) de mouvement 5. Les résultats de cette ou ces estimation(s) sont traités par des circuits non représentés sur la figure 1. Le signal est d'autre part soumis à une transformation cosinus discrète (DCT) par un circuit approprié 6, qui effectue aussi la quantification des coefficients. Ces coefficients ou des combinaisons de coefficients non nuls et de longueurs de séries de coefficients nuls sont finalement codés par un procédé de codage à longueur variable de type connu, par exemple le codage par la méthode d'Huffman (circuit 8). Un buffer 9 recueille le signal compressé issu du codeur pour l'émettre en fonction de la capacité du canal de transmission, canal non représenté sur la figure 1. Un problème apparaît lorsque le buffer 9 se remplit plus vite qu'il ne se vide. Dans certains cas, cela peut conduire à un débordement dudit buffer et donc à une perte de données. Pour éviter ce problème, une boucle de retour de réglage de débit 10 contrôle la quantification des coefficients de la DCT, et par conséquent le débit des données vers le buffer 9. Il apparaît donc comme nécessaire de procéder à un codage VLC des données avant de pouvoir connaître le budget de bits correspondant, c'est à dire le nombre de bits nécessaires pour coder le signal ou la partie de signal sous forme compressée. Cette solution est peu satisfaisante, car on est obligé d'effectuer un certain nombre de calculs inutiles, si le codage est effectué en deux passes, la première destinée à une première estimation du budget de bits, la seconde au codage en soi, avec éventuellement une correction en fonction des résultats de la première passe. Il en résulte une perte de temps et d'énergie, ainsi qu'une complexité accrue des circuits.

L'invention a pour but d'éviter ces inconvénients.

L'invention a d'autre part pour but de permettre une estimation du débit de données issu du codeur, ceci avant le codage à longueur de mot variable.

L'invention a pour objet un procédé d'estimation d'un budget de bits dans un circuit de compression de données numériques, notamment de signaux de télévision numérisés tel que défini à la revendication 1. Le procédé est spécifique en ce que, lesdits signaux étant représentés par des échantillons de N bits, l'estimation est basée sur la probabilité qu'a un bit de poids donné d'avoir une valeur donnée 0 ou 1 parmi M mots binaires représentant M échantillons d'un signal, un calcul d'entropie étant effectué pour chaque poids de bit sur la base desdites probabilités correspondant aux N bits, la somme de toutes les entropies correspondant à l'estimation désirée.

On connaît la performance de certaines méthodes de codage par rapport à la limite inférieure que constitue l'entropie. Dans le cas de la méthode de codage d'Huffman, on sait que le nombre de bits moyen nécessaire pour coder un échantillon du signal est au plus supérieur d'un bit par rapport à l'entropie. Connaissant l'entropie, ou du moins une estimation de l'entropie, on connaîtra, avant même le codage, le débit, ou du moins une estimation du débit auquel il faut s'attendre.

Dans le procédé selon l'invention, on tient compte de la corrélation entre bits de même poids parmi les M échantillons du signal au lieu de tenir compte directement de la corrélation entre les échantillons en soi. Nécessairement, l'estimation ainsi obtenue est supérieure à la valeur que l'on trouverait par un calcul entropique classique. Mais le nombre de comparateurs et de compteurs nécessaires pour le calcul est réduit au nombre de bits dans chaque échantillon dans le cas de l'estimation, ce qui représente un gain de matériel appréciable par rapport au calcul classique nécessitant $2^N$ comparateurs et compteurs (un comparateur et un compteur par valeur possible pour les échantillons).

L'invention a aussi pour objet un dispositif mettant en oeuvre ledit procédé, tel que défini à la revendication 5.

Selon une utilisation particulière du procédé conforme à l'invention, l'estimation du budget de bits sert à prévoir le débit des données issues du codeur.

Selon une utilisation particulière de l'invention, l'estimation du budget de bits sert à réguler le degré de remplissage du buffer vidéo et donc à adapter le codage au débit du canal de transmission.

Le procédé conforme à l'invention peut être appliqué à toutes sortes de données, que ce soit dans le domaine temporel ou fréquentiel.

D'autres avantages de l'invention apparaîtront à travers la description du mode de réalisation préférentiel non limitatif, représenté par les figures jointes, parmi lesquelles:

la figure 1, déjà décrite, représente un diagramme fonctionnel partiel d'un circuit de compression de signaux de télévision,

la figure 2 représente le diagramme fonctionnel d'un exemple d'implémentation du procédé conforme à l'invention,

la figure 3 représente le diagramme fonctionnel d'un circuit de calcul de l'entropie correspondant à un bit de poids $2^i$ ledit circuit étant utilisé dans le diagramme de la figure 2.

Un échantillon représenté par un mot binaire de longueur N est de la forme:

$$b_{N-1} b_{N-2} \dots b_i \dots b_1 b_0$$

bi est le bit de poids $2^i$ ($0 \leq i \leq N-1$), chaque bit pouvant prendre la valeur 0 ou 1.

On détermine, pour chaque bit bi, le nombre de fois Ci que ce bit prend la valeur 1 dans les M échantillons. La probabilité que bi prenne la valeur 1 est alors pi = Ci/M. La probabilité que bi prenne la valeur 0 est bien évidemment qi = 1-Ci/M.

L'entropie, pour ce bit, est calculée de façon classique en utilisant la formule:

$$H_i = p_i Log_2 p_i - q_i Log_2 q_i$$

Ce qui est équivalent à :

$$H_i = -(C_i/M)Log_2(C_i/M) - (1-C_i/M)Log_2(1- C_i/M)$$

On somme ensuite les entropies pour tous le bits bi. Cette somme représente l'estimation désirée. En sommant sur les N bits, on obtient l'estimation du budget de bits. En divisant par M, on obtient l'estimation du nombre moyen de bits nécessaires pour coder un mot :

$$\mathbf{H_{estimé}} = \mathbf{NLog_2 M} - \frac{1}{\mathbf{M}} \sum_{i=0}^{N-1} \left[ \mathbf{C_i Log_2 C_i} + (\mathbf{M} - \mathbf{C_i}) \mathbf{Log_2}(\mathbf{M} - \mathbf{C_i}) \right]$$

bits/mot (1)

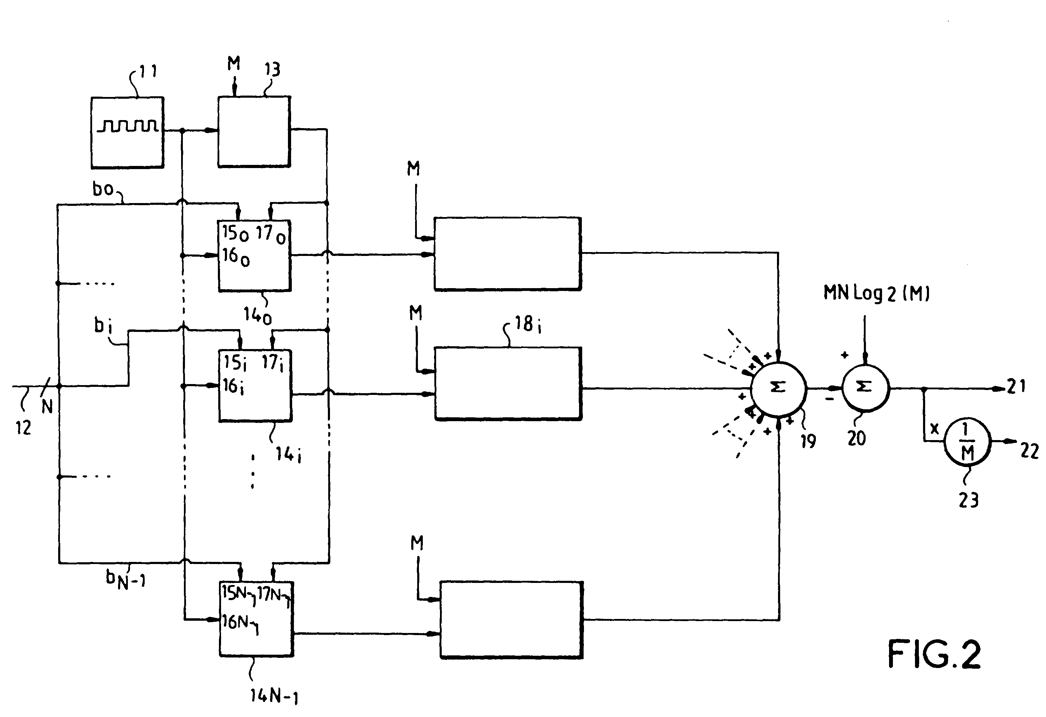

La figure 2 montre un diagramme fonctionnel d'un circuit d'estimation du nombre de bits nécessaires pour coder un signal représenté par M échantillons de N bits. Le circuit comprend une horloge 11 synchrone avec la fréquence des données sur un bus 12. L'horloge 11 fournit un créneau lorsque les données sont établies sur le bus 12.

Chaque ligne du bus 12 correspond à un bit bi d'un échantillon représentant le signal et est connectée à l'entrée 15i d'un compteur à L bits 14i. Les compteurs 14i sont tels qu'il permettent de compter au moins jusqu'à M. On choisira donc L tel que $2^{(L-2)} < M \leq 2^{(L-1)}$. Lesdits compteurs possèdent d'autre part une entrée d'horloge 16i, ainsi qu'une entrée de remise à zéro 17i. Les entrées d'horloge 17i sont connectées à l'horloge 12, tandis que les entrées de remise à zéro sont connectées à la sortie d'un circuit 13.

Ledit circuit 13 comporte un compteur et un comparateur et fournit un signal sur sa sortie chaque fois que M signaux d'horloge ont été comptés.

Les compteurs 14i s'incrémentent d'une unité lorsqu'au moment du front montant de l'horloge 12 sur l'entrée 16i, l'entrée 15i est à 1.

Au début d'une phase d'estimation, tous les compteurs (compteurs 14i et compteur du circuit 13) sont à zéro. A chaque fois qu'une donnée correspondant à un signal numérisé se stabilise sur le bus 12, l'horloge 11 envoie une impulsion. Les compteurs 14i s'incrémentent alors si leur entrée 15i est haute. Le compteur du circuit 13 compte le nombre d'impulsions données par l'horloge. Si ce nombre dépasse M, le circuit 13 remet son propre compteur et les compteurs 14i à zéro.

Selon une variante de réalisation, l'état du compteur du circuit 13 est fourni à un circuit supplémentaire non représenté qui élabore un signal lorsque M mots ont été comptés, de façon à avertir à quel moment un résultat correct est disponible aux sorties 21 et 22. Les modalités de mise en oeuvre d'une telle réalisation sont à la portée de l'homme du métier.

La sortie de chaque compteur 14i est connectée à l'entrée d'un circuit correspondant 18i décrit ultérieurement. Les circuits 18i fournissent chacun l'entropie correspondant au bit bi. Les entropies sont sommées par un sommateur 19. Le résultat est retiré au terme constant NLogM de l'équation (1) par le sommateur 20. Suivant que l'on désire une estimation du nombre total de bits nécessaire pour coder les M échantillons ou du nombre moyen de bits par échantillon, on choisira respectivement la sortie 21 ou la sortie 22. La sortie 21 correspond directement à la sortie du sommateur 20, tandis que la sortie 22 correspond à cette sortie vue à travers un diviseur par M 23.

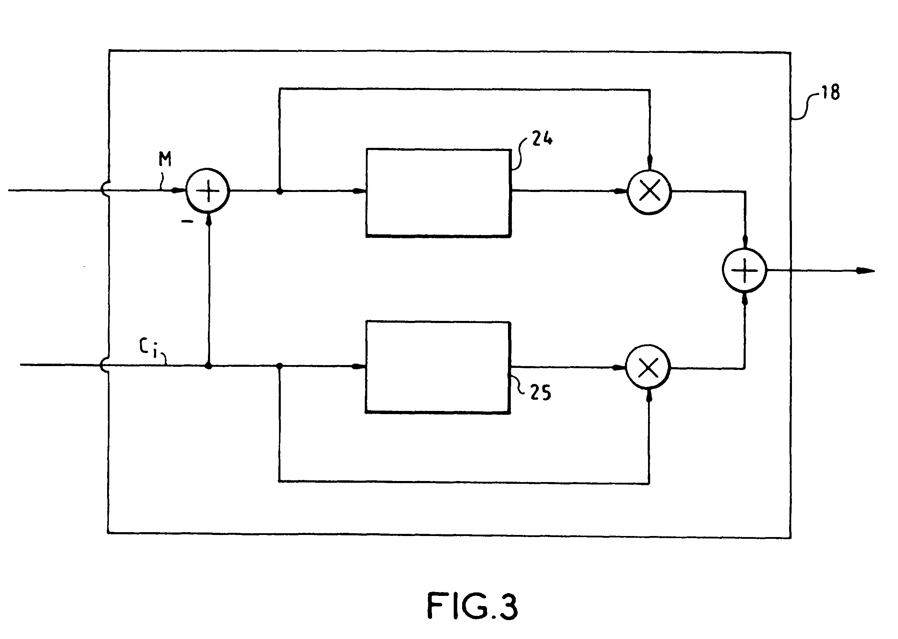

Le figure 3 représente un diagramme fonctionnel correspondant à l'un des circuits 18i. Ce circuit possède en entrée les valeurs de M, ainsi que les valeurs de Ci correspondant au nombre de fois qu'un bit bi était à 1 dans les M échantillons.

Le circuit comprend principalement deux tables logarithmiques 24 et 25 de base 2. Ces circuits ont la particularité de fournir un zéro en sortie quand un zéro est présenté à leur entrée, même si le log de zéro n'est normalement pas défini.

L'entrée de la table 24 reçoit le terme M-Ci, tandis que la table 25 reçoit le terme Ci. Les sorties des tables vont chacune vers un multiplicateur recevant d'autre part respectivement M-Ci et Ci. Les sorties des deux multiplicateurs sont ensuite additionnés pour fournir la sortie du circuit 18i.

Selon une variante de réalisation, une seule mémoire de logarithmes est utilisée pour tous les circuits 18i, un microprocesseur ou équivalent étant employé pour fournir les valeurs à partir de cette mémoire.

Selon une variante de réalisation, le circuit 13 comporte une remise à zéro qui permet de choisir exactement à partir de quel échantillon on désire commencer l'estimation, en appliquant au moment voulu un signal sur cette entrée.

L'estimation obtenue peut ensuite être utilisée par les autres circuits du dispositif de compression, notamment pour réguler le degré de remplissage du buffer de données compressées, ou pour adapter la quantification des coefficients. L'interaction du dispositif d'estimation selon l'invention avec le dispositif d'ensemble dans lequel il sera implémenté ainsi que la régulation en soi se feront selon l'un des schémas connus par l'homme de métier concerné.

Selon un mode de réalisation particulier, l'estimation du budget de bits est effectuée dans une première passe du codeur, le résultat correspondant étant ensuite utilisé pour adapter la quantification des coefficients pendant une seconde passe pour obtenir le débit de bits désiré, ladite seconde passe se terminant par le codage VLC véritable, tandis que la première passe se termine par l'estimation du budget de bits selon le procédé conforme à l'invention.

Selon un mode de réalisation particulier, l'estimation selon le procédé conforme à l'invention est obtenue après que les données aient été soumises à une transformation Walsh-Hadamard au lieu d'une transformation DCT. La transformée Walsh-Hadamard est plus simple à mettre en oeuvre que la transformée DCT, n'exigeant que des additions et des soustractions et non des multiplications. On pourra également utiliser l'estimation obtenue grâce au procédé conforme à l'invention après une transformation Walsh-Hadamard pour adapter la quantification de coefficients obtenus par DCT.

D'autres implémentations du procédé que celle donné dans l'exemple ci-dessus sont bien sûr possibles. Certaines étapes pourront notamment être mises en oeuvre grâce à un microprocesseur.

Le procédé d'estimation du budget de bits peut bien évidemment être utilisé dans d'autres applications comportant des codeurs à longueur variable.

**Revendications**

1. Procédé d'estimation d'un budget de bits dans un circuit de compression de données numériques, notamment de signaux de télévision numérisés, lesdits signaux étant représentés avant compression par des échantillons codés sur N bits,
   caractérisé par le fait que l'estimation est basée sur la probabilité qu'à chaque bit de poids donné d'avoir une valeur 0 ou 1 parmi M mots binaires représentant M échantillons du signal, un calcul des entropies associées aux bits de poids donné étant effectué sur la base desdites probabilités, la somme desdites entropies correspondant à l'estimation désirée.

2. Procédé selon la revendication 1, caractérisé en ce qu'on détermine, parmi les M mots binaires, le nombre de fois Ci, $0 \leq i \leq N-1$, qu'un bit de poids donné i possède ladite valeur donnée et qu'on en déduit l'entropie Hi de ce bit de poids donné i.

3. Procédé selon l'une des revendications précédentes, caractérisé en ce que lorsque les M mots binaires ont été traités, on somme les entropies Hi pour obtenir l'estimation du budget de bits désirée.

4. Procédé selon l'une des revendications précédentes, caractérisé en ce que l'estimation du nombre moyen de bits nécessaires pour coder un mot est:

$$H_{estimé} = NLog_2M - \frac{1}{M} \sum_{i=0}^{N-1} \left[ C_i Log_2 C_i + (M - C_i)Log_2(M - C_i) \right]$$

5. Dispositif mettant en oeuvre le procédé selon l'une des revendications précédentes, caractérisé en ce qu'il comprend N compteurs de L bits (14i) chacun avec L tel que $2^{(L-2)} < M \le 2^{(L-1)}$, chacun de ces compteurs (14i) comptabilisant le nombre de fois Ci qu'un bit bi de poids donné i, $0 \le i \le N$-1, possède une valeur 0 ou 1 donnée parmi M mots binaires, le dispositif comprenant d'autre part pour chacun des compteurs deux tables (24, 25) de logarithmes base 2 aux entrées desquelles on applique d'une part Ci, d'autre part M-Ci, lesdites tables (24,25) fournissant en sortie soit le logarithme correspondant, soit la valeur zéro si leur entrée est nulle, ladite sortie de chacune des tables étant multipliée par la valeur à son entrée, l'ensemble des résultats de ces 2N multiplications étant additionné pour être soustrait au terme constant $NLog_2M$.

6. Dispositif de compression de signaux de télévision comprenant un circuit de transformation dans le domaine des fréquences (6), un codeur à longueur variable (8), ainsi qu'un buffer de sortie (9) caractérisé en ce que ledit dispositif comprend des moyens d'estimation (11 à 25) mettant en oeuvre le procédé conforme à l'une des revendications 1 à 4, l'estimation résultante étant utilisée par un circuit de réglage de débit (10) pour régler le débit des signaux compressés vers ledit buffer de sortie (9) en adaptant le taux de compression desdits signaux, lesdits moyens d'estimation comprenant des moyens (13) pour calculer pour chaque poids de bit i, la probabilité qu'ont les bits de ce poids i d'avoir une valeur 0 ou 1 parmi les M mots binaires représentant M échantillons de signaux avant compression, un calcul d'entropie pour chaque poids donné étant effectué sur la base desdites probabilités, et des moyens (19) pour sommer les entropies correspondant à l'ensemble desdits poids, avec $0 \le i \le N$ - 1, lesdits échantillons étant codés sur N bits avant compression.

**Patentansprüche**

1. Verfahren zur Bitmengenschätzung in einer Schaltung zum Komprimieren von digitalen Daten, insbesondere von digitalisierten Fernsehsignalen, wobei diese Signale vor der Komprimierung durch auf N Bit kodierte Abtastwerte dargestellt werden,
dadurch gekennzeichnet, daß die Schätzung auf der Wahrscheinlichkeit beruht, mit der jedes Bit einer bestimmten Wertigkeit einen Wert 0 oder 1 unter M binären Wörtern hat, die M Abtastwerte des Signals darstellen, daß eine Berechnung der den Bits mit bestimmter Wertigkeit zugeordneten Entropiewerte auf der Basis dieser Wahrscheinlichkeiten erfolgt und die Summe dieser Entropiewerte der gewünschten Schätzung entspricht.

2. Verfahren nach Anspruch 1, dadurch gekennzeichnet, daß unter M binären Wörtern die Anzahl der Fälle Ci, $0 \le i \le N$-1, bestimmt wird, bei denen die gegebene Wertigkeit i den gegebenen Wert aufweist, und daß daraus die Entropie Hi dieses Bits mit der gegebenen Wertigkeit i abgeleitet wird.

3. Verfahren nach einem der vorangehenden Ansprüche, dadurch gekennzeichnet, daß dann, wenn die M binären Wörter verarbeitet werden, die Entropiewerte Hi summiert werden, um daraus die gewünschte Bitmengenschätzung zu erhalten.

4. Verfahren nach einem der vorangehenden Ansprüche, dadurch gekennzeichnet, daß die Schätzung der mittleren Anzahl der zum Kodieren eines Wortes notwendigen Bits folgenden Wert hat:

$$H_{\text{geschätzt}} = NLog_2M - \frac{1}{M}\sum_{i=0}^{N-1}[C_iLog_2C_i + (M - C_i)\,Log_2\,(M - C_i)\,]$$

**5.** Vorrichtung zur Durchführung des Verfahrens nach einem der vorangehenden Ansprüche, gekennzeichnet durch N Zähler (14i) mit L Bit jedes mit einem L derart, daß $2^{(L-2)} < M \leq 2^{(L-1)}$ ist, wobei jeder der Zähler (14i) die Anzahl der Fälle Ci zählt, bei denen ein Bit bi mit der gegebenen Wertigkeit i, $0 \leq i \leq N-1$, einen gegebenen Wert 0 oder 1 unter M binären Wörtern aufweist und die Vorrichtung andererseits für jeden der Zähler zwei Logarithmentabellen (24, 25) auf der Basis 2 enthält, deren Eingängen einerseits Ci, andererseits M-Ci zugeführt wird, und die Tabellen (24,25) am Ausgang den Logarithmus liefern, der dem Wert null entspricht, wenn ihr Eingang null ist, und der Ausgang jeder der Tabellen mit dem Wert an ihrem Eingang multipliziert wird, und die Anordnung der Resultate dieser zwei 2N Multiplikationen addiert und von einem konstanten Ausdruck $Nlog_2M$ subtrahiert wird.

**6.** Vorrichtung zur Komprimierung von Fernsehsignalen mit einer Schaltung (6) zur Transformation in den Frequenzbereich, einem Koder (8) mit variabler Länge und mit einem Ausgangs-Pufferspeicher (9), dadurch gekennzeichnet, daß die Vorrichtung Mittel (11 bis 25) zum Schätzen enthält, die das Verfahren nach einem der Ansprüche 1 bis 4 ausführen, wobei die resultierende Schätzung von einer Schaltung (10) zur Regelung der Datenmenge benutzt wird, um die Datenmenge der für den Ausgangspufferspeicher (9) komprimierten Signale zu regeln, indem die Koprimierraten dieser Signale angepaßt werden, wobei die Mittel zum Schätzen Mittel (13) enthalten zum Berechnen der Wahrscheinlichkeit für jede Wertigkeit des Bits bi, mit der die Bits dieser Wertigkeit i einen Wert 0 oder 1 unter den M binären Wörtern haben, die M Abtastwerte der Signale vor der Komprimierung darstellen, daß eine Berechnung der Entropie für jede gegebene Wertigkeit auf der Grundlage der genannten Wahrscheinlichkeiten durchgeführt wird, und wobei Mittel (19) vorgesehen sind zum Summieren der der Anordnung der genannten Wertigkeiten entsprechenden Entropiewerte, wobei $0 \leq i \leq N - 1$ ist, und die Abtastwerte vor der Komprimierung auf N Bits kodiert werden.

## Claims

1. Process for estimating a bit budget in a circuit for compressing digital data, especially digitized television signals, the said signals being represented before compression by N-bit coded samples, characterized in that the estimate is based on the probability of each bit of given order having a given value 0 or 1 out of M binary words representing M samples of the signal, a calculation of the entropies associated with the bits of given order being performed on the basis of the said probabilities, the sum of the said entropies corresponding to the desired estimate.

2. Process according to Claim 1, characterized in that the number of times Ci, $0 \leq i \leq N-1$, that a bit of given order i possesses the said given value is determined out of the M binary words, and from this the entropy Hi of this bit of given order i is deduced.

3. Process according to any one of the preceding claims, characterized in that when the M binary words have been processed, the entropies Hi are summed to obtain the desired estimate of the bit budget.

4. Process according to any one of the preceding claims, characterized in that the estimate of the mean number of bits required to code a word is:

$$H_{\text{estimated}} = NLog_2M - \frac{1}{M}\sum_{i=0}^{N-1}\left[C_iLog_2C_i + \left(M - C_i\right)Log_2\left(M - C_i\right)\right]$$

5. Device implementing the process according to any one of the preceding claims, characterized in that it comprises N L-bit counters (14i) each with L such that $2^{(L-2)} < M \leq 2^{(L-1)}$, each of these counters (14i) counting up the number of times Ci that a bit bi of given order i, $0 \leq i \leq N-1$, possesses a given value O or 1 out of M binary words, the device furthermore comprising for each of the counters two tables (24, 25) of logarithms to the base 2 to whose inputs are applied on the one hand Ci and on the other hand M-Ci, the said tables (24, 25) delivering as output either the corresponding logarithm, or the value zero if their input is zero, the said output from each of the tables being multiplied by the value at its input, the results of these 2N multiplications being added together so as to be subtracted from the constant term $NLog_2M$.

6. Device for compressing television signals comprising a frequency domain transformation circuit (6), a variable-length coder (8), as well as an output buffer (9) characterized in that the said device comprises estimation means (11 to 25) implementing the process in accordance with one of Claims 1 to 4, the resulting estimate being used by a throughpu adjustment circuit (10) to adjust the throughput of the compressed signals heading for the said output buffe (9) by adapting the compression factor for the said signals, the said estimating means comprising means (13) for calculating, for each order of bit i, the probability of the bits of this order i having a value 0 or 1 from among the M binary words representing samples of signals before compression, a calculation of entropy for each given order being performed on the basis of the said probabilities, and means (19) for summing the entropies corresponding to all the said orders, with $0 \leq i \leq N-1$, the said samples being coded over N bits before compression.

FIG.1

FIG.2

FIG.3